# EUROPEAN PATENT APPLICATION

(11) **EP 3 115 137 A1**
(43) Date of publication of application: **11.01.2017**
(21) Application number: 15175706.9
(22) Date of filing: 07.07.2015
(51) Int. Cl.: B23B 51/02, B23B 27/14, B23P 15/28, C23C 16/02

(54) **A MACHINING TOOL**

(71) Applicant: ThyssenKrupp Metalúrgica Campo Limpo Ltda., 13231-900 Campo Limpo Paulista-SP (BR); ThyssenKrupp AG, 45143 Essen (DE)
(72) Inventor: GUERREIRO, Sergio Stefano, 13240-000 Jardim Pagliato, Sorocaba - SP (BR); SALLES, Bruno Barbosa de Oliveira Ferreira, 13060-073' Jardim Pauliceia, Campinas - SP (BR)
(74) Representative: ThyssenKrupp Intellectual Property GmbH

(57) **Abstract**

A machining tool (1), comprising at least one cutting edge (3) for chipping material from a workpiece to be machined,
wherein the at least one cutting edge (3) of the tool comprises a metal core (4), which is covered by a coating (5),
wherein a surface (9) of the metal core (4) comprises at least in the area of the cutting edge (3) a texture (6), having a plurality of cavities (7).

## Description

The present invention refers to a machining tool and a method for manufacturing a machinig tool.

### PRIOR ART

The drilling process is usually a critical step in the manufacturing process of mechanical components. Occasionally, the required time to perform this operation is relatively high when compared to remaining operations, which occasionally results in this process becoming the bottle neck of the production line. Furthermore, the drills wear and consumption is significant, with direct impact in the overall expenses of the machining shop.

The coating of the drills wears off or breaks off the drill after a certain number of drilling operations, so it becomes necessary to recondition or exchange the drills in regular intervalls. This increases standstill occurences of the drilling machine with further impact on the overall production line. The reconditioning and respectively exchange of drills generates extra costs.

For the drilling process twisted drills are used. US 6,524,036 B1 discloses a respective twisted drill. To optimize the swarf flow behaviour of the drill a tool surface is roughened with a geometric pattern spaced at a slight distance to the region of the cutting edges, which leads to a faster removal of the metal swarf during drilling. The roughening is performed by laser irradiation. After the laser treatment the drill is coated with a hard metal layer.

In certain embodiments a rough surface of the metal core also causes an increase of friction occurring during machining, which causes higher temperatures and thus higher wear of the tool.

### DISCOLSURE OF INVENTION

With these facts in mind the necessity of machining tools improvement arises. The object of the invention is thus to improve the machining tools with respect to service life and overall costs.

This object is achieved by a machining tool taught by claim 1 and is further achieved by a method for manufacturing a machining tool according to claim 6. Preferred embodiments of the invention are defined by the subclaims.

The invention provides a machining tool, in particular a twisted drill, comprising at least one cutting edge for chipping material from a workpiece to be machined, wherein the at least one cutting edge has a metal core, which is covered by a coating. A surface of the metal core comprises at least in the area of the cutting edge a texture, having a plurality of cavities.

It is an advantage of the present invention, that specially in the cutting edge area the surface comprises a texture, which increases the roughness of the surface, so that the adherence of the coating is increased. The cavities serve furthermore as a receptacle for lubricant. Therefore the cavities have a specific deepness, which is in particular greater than a layer thickness of the coating, so that the cavities are also present on the surface after coating.

Furthermore it is advantageous, that the cavities are encompassed by crater of debris and/or burrs, wherein the crater of debris and/or burrs protrudes from the surface of the core. These craters constitute peaks protruding from the surface of the metal core. Covered with coating, these peaks are the actually abrasive sections of the machining tool. Compared to a more hommogenous surface the total area of actually abrasive sections is reduced. This leads to the main advantage, that the total friction occurring during chipping is reduced, which leads to less heat production and thus less wear of the tool.

Experiments show, that the service life of the machining tools can be significantly increased by providing one or more of the following parameters to the tool:
The texture comprise at least a first plurality of cavities. In a preferred embodiment a mean distance between the first cavities, measured from a center of the first cavities, is about 20 to 30 µm, in particular about 25 µm in the longitudinal direction (parallel to the axis of the tool) and about 13 to 30 µm, in particular about 20 µm, in the transversal direction (perpendicular to the axis of the tool).

In a further preferred embodiment the texture comprises a plurality of second cavities, which partially overlap the first cavities. A mean distance between the second cavities, measured from a center of the second cavities, is about 20 to 30 µm, in particular about 25 µm, in the longitudinal direction (parallel to the axis of the tool) and about 13 to 30 µm, in particular about 20 µm, in the transversal direction (perpendicular to the axis of the tool).

Preferably the craters of debris and/or burrs have a mean height over a mean surface of the metal core from 1 to 3 µm, in particular about 1.2 µm; this height is in particular measured from a mean level of the surface of the metal core.

In an embodiment the cavities are arranged in parallel rows. This enables an easy production of the cavities by a laser tool which is driven laterally over the surface of the metal core.

The invention provides further a method for manufacturing a machining tool, in particular a machining tool according to claim 1. The tool, in particular a twisted drill, comprises at least one cutting edge for chipping material from a workpiece to be machined, wherein the at least one cutting edge comprises a coating covering a metal core. The method comprising the steps of: introducing a texture on to the surface of the metal core before coating by creating a plurality of cavities into the surface; applying a coating onto the surface of the metal core thereby covering the cavities by the coating.

The advantages and further embodiments described with reference to the machining tool are also applicable to the claimed method.

Thereby it is advantageous, that the step of introducing a texture comprise accumulation of debris and/or burrs at the border of the cavities, protruding from the surface of the metal core.

In an embodiment the texture is introduced into the surface by means of laser printing. During laser printing the tool is in particular rotated along an axis of rotation and the laser or the tool is driven parallel to the axis of rotation. When the laser or the tool is driven continuously a rows of cavities are created, which have helical shapes. When the laser or the tool is driven in incremental steps, rows of cavities can be created, which are perpendicular to the rotational axis of the tool, in particular if a step of the axial movement is conducted exactly after one rotation of the tool. Both options are feasible.

In an embodiment, after a first laser treatment the surface of metal core is exposed to a second laser treatment, covering the same areas of the surface of the metal core which partly overlap those areas which were exposed to the first laser treatment. Experiments show tools applied with the second laser treatment having an improved service life. A reason for this improvement lies in the fact, that during the second laser treatment too large crater of debris and/or burrs are remelted, consequently some kind of smoothening of the surface is realised. This is an important improvement, since the aforementioned positive effects of the crater can be jeopardised, if the crater protrudes too much from the surface; the second laser treatment reduces an unwanted high protrusion of the crater.

Experiments show, that the service life of the machining tools can be significantly increased by providing one or more of the following parameters to the laser treatment:
A laser beam produced by the laser has a light power from 5 W to 10 W, in particular about 7,2 W. The laser beam produced by the laser has a wavelength from 970 to 1170 nm, in particular of about 1070 nm. The laser beam has a repetition rate of 50 kHz and/or a pulse width of 200 ns. The laser beam is driven over the surface of the metal core at a speed from 800 to 1200 mm/s, in particular about 1000 mm/s.

### EXAMPLE EMBODIEMENT OF THE INVENTION

Embodiments of the invention are subsequently disclosed with reference to the accompanied figures; the figures show:
- Fig. 1: a twisted drill during laser texturing according to the invention;
- Fig 2.: a cross section of the cutting edge of an inventive drill;
- Fig. 3: a developed view on the surface of the main core of the drill of figure 2 after a first laser treatment before coating;
- Fig. 4: a developed view on the surface of the main core of the drill of figure 2 after a second laser treatment before coating.

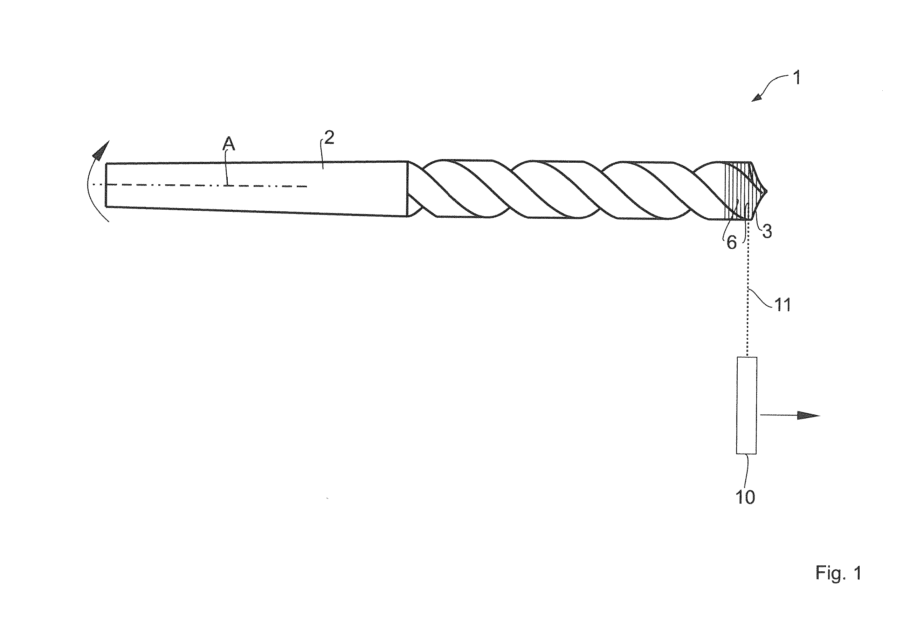

Figure 1 shows a machining tool 1, in the previous embodiment the machining tool is a twisted drill. The drill 1 comprises a shaft 2 for mounting the drill onto a machining machine. The drill 1 comprises a metal core 4 covered by a coating 5. The metal core is made from cemented carbide with an approximate hardness of 1620 HV. The coating may be from any material metallic or non-metalic . The metal core 4 is provided with a texture 6, which is applied on the metal core 4 before coating. As can be seen in figure 1 the texture 6 is provided in parallel arranged rows. The texture is applied to the metal core 4 by means of a laser 10. During application of the texture the drill 1 is rotated around the axis of rotation A of the drill 1. Simultaneously the laser 10 is moved parallel to the axis of rotation A, so that several lines of the texture are produced. It is immaterial, whether the laser 10 or the drill 1 is moved during application of the texture, merely important is the relative movement between drill 1 and laser 10 during laser treatment. The invention is also applicable to other machining tools comprising a cutting edge 3 for chipping material from a workpiece to be machined.

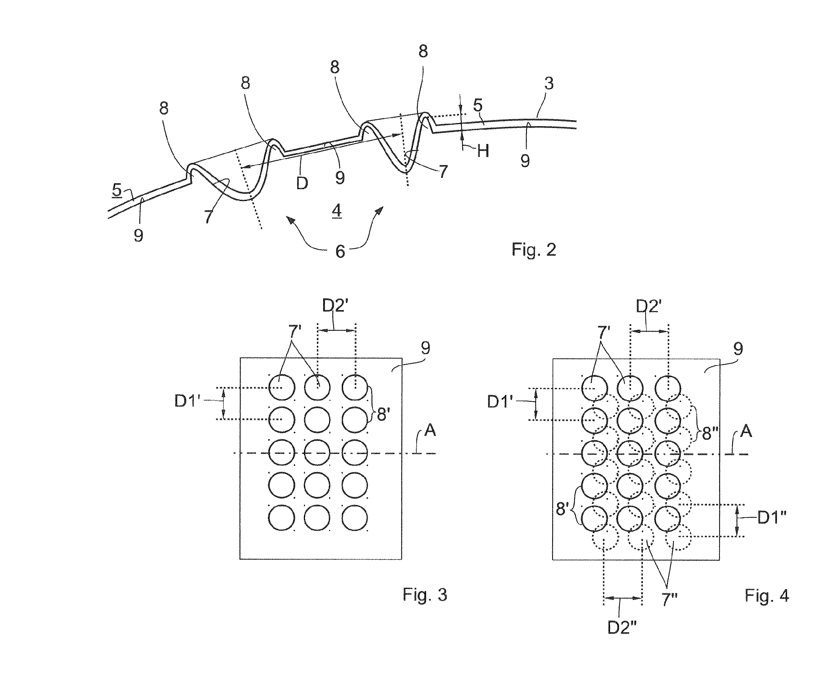

Figure 2 shows a crosssection of the twisted drill 1 in the area of the cutting edge 3. The surface 9 of the metal core 4 is covered by the coating 5. Before coating, cavities 7 are created by means of the aforementioned laser treatment. The laser thereby impinges into the surface 9 of the metal core 4 and melts material from the core 4 so that the cavities 7 are created. At the border of the cavities 7 crater of debris and/or burrs 8 arise and protrude from the surface 9 of the metal core 4.

Subsequently the surface 9 of the metal core 4 as well as the craters of debris and/or burrs 8 and the cavities 7 are completely covered by the coating 5. The coating is applied e.g. by PVD or CVD. The thickness of the coating 5 is smaller than the height of the crater, so that the texture is also tactile on the surface of the coating 5.

Figure 3 shows a developed view of the surface 9 before application of the coating 5. A plurality of first cavities 7' is arranged in parallel rows. The distance D1 between the first cavities 7' is about 25 µm, measured from the center of a row of cavities to the adjacent row of cavities. The distance D2 is about 20 µm, measured from the center of each first cavity 7 to the adjacent first cavity 7, and is given by the speed of the laser beam divided by the laser frequency.

The texturing provides a better adherence of the coating to the metal core. Further and more important is, that the craters of debris and/or burrs 8 provide abrasive peaks, which get into contact during chipping of the workpiece. Compared to conventional drills, the surface, whichs gets in contact with the workpiece is massively reduced. Thus the friction between workpiece and drill 1 is considerably reduced, which in turn reduces the heat generation during chipping. This has a further positive impact on the service life of the drill 1.

The laser 10 is a 20 watt fibre pulsed laser with a wavelength of 170nm, using a F-theta lens of 166 mm. The power of the laser was set to 7.2 watt, repetition rate of 50 kHz, the relative feed speed of the laser beam 11 relatively to the surface 9 is 1000 mm/s. The drill was fixed in a rotational axis and the laser beam was applied perpenticular to the drills axis.

After a first laser treatment was applied to the surface 9 covering the complete area of the cutting edge 3, a second laser treatment with the same parameters was provided to the surface 9. This had the main effect, that very large peaks were removed from the surface respectively polished from the surface. Especially large craters of debris and/or burrs 8 were thus reduced in their heights. Figure 4 shows schematically the developed view of the surface after the second laser treatment. The surface comprises second cavities 7" encompassed by second craters 8" (dotted line) of debrisand/or burr. The second craters of debris and/or burrs, created during the second laser treatment, partially overlap the first craters 8' of debris and/or burrs, created during the first laser treatment.

### LIST OF REFERENCE SIGNS

- 1: twist drill
- 2: shaft
- 3: cutting edge
- 4: metal core
- 5: coating
- 6: texturing
- 7: cavities
- 8: debris and/or burrs
- 9: mean core surface
- 10: laser
- 11: laser beam

- A: axis of rotation
- D: distance
- H: height

## Claims

1. A machining tool (1), in particular a twisted drill (1), comprising at least one cutting edge (3) for chipping material from a workpiece to be machined,
wherein the at least one cutting edge (3) of the tool comprises a metal core (4), which is covered by a coating (5),
**characterized in**
**that** a surface (9) of the metal core (4) comprises at least in the area of the cutting edge (3) a texture (6), having a plurality of cavities (7).

2. Machining tool (1) according to the preceding claim,
**characterized in**
**that** the cavities (7) are encompassed by a crater of debris and/or burrs (8), wherein the crater of debris and/or burrs (8) protrudes from the surface (9) of the core (4).

3. Machining tool (1) according to any of the preceding claims,
**characterized in**
**that** the texture (6) comprises a plurality of first cavities (7'), and
**that** a mean distance (D1) between two adjacent rows of the first cavities (7'), measured from a center of the first cavities (7'), of each row, is about 20 to 30 µm, in particular about 25 µm, and a mean distance (D2') between two first cavities (7'), measured from a center of the first cavities (7'), of the same row is about 13 to 30 µm, in particular about 25 µm.

4. Machining tool (1) according to the preceding claim,
**characterized in**
**that** the texture (6) comprises a plurality of second cavities (7") partially overlapping the first cavities (7'), and
**that** a mean distance (D1") between two adjacent rows of the second cavities (7"), measured from a center of the second cavities (7"), of each row, is about 20 to 30 µm, in particular about 25 µm, and a mean distance (D2") between two second cavities (7"), measured from a center of the second cavities (7"), of the same row is about 13 to 30 µm, in particular about 25 µm.

5. Machining tool (1) according to any of claims 2 to 4,
**characterized in**
**that** the craters of debris and/or burrs (8) have a mean height (H) over a surface (9) of the metal core from 1 to 3 µm, in particular about 1.2 µm.

6. Machining tool (1) according to any of the preceding claims,
**characterized in**
**that** the cavities (7) are arranged in parallel rows.

7. A method for manufacturing a machining tool (1), comprising at least one cutting edge (3) for chipping material from a workpiece to be machined,
wherein the at least one cutting edge (3) comprises a coating (5) covering a metal core (4),
the method comprising the steps of:
introducing a texture (6) on to the surface (9) of the metal core (4) before coating by creating a plurality of cavities (7) into the surface (9),
applying a coating (5) onto surface (9) of the metal core (4) thereby covering the cavities (7) by the coating (5).

8. Method according to the previous claim,
**characterized in**
**that** the step of introducing a texture (6) comprise accumulation of debris and/or burrs (8) at the border of the cavities (7), protruding from the surface (9) of the metal core (4).

9. Method according to any of claims 7 or 8,
**characterized in**
**that** the texture (6) is introduced into the surface by means of a laser (10) by laser printing.

10. Method according to the previous claim,
**characterized in**
**that** during laser printing the tool (1) is rotated along an axis of rotation (A) and the laser (10) or the tool (1) is driven parallel to the axis of rotation (A).

11. Method according to any of claims 9 or 10,
**characterized in**
**that** after a first laser treatment the surface (9) of the metal core (9) is exposed to a second laser treatment, covering areas of the surface (9) of metal core (4) which partly overlap those areas which were exposed to the first laser treatment.

12. Method according to any of claims 9 to 11,
**characterized in**
**that** a laser beam (11) produced by the laser (10) has a light power from 5 W to 10 W, in particular about 7,2 W.

13. Method according to any of claims 9 to 12,
**characterized in**
**that** a laser beam (11) produced by the laser (10) has a wavelength from 970 to 1170 nm, in particular about 1070 nm.

14. Method according to any of claims 9 to 13,
**characterized in**
**that** a laser beam (11) has a repetition rate of 40 to 60 kHz, in particular of about 50 kHz, and/or a pulse width of 200 ns.

15. Method according to any of claims 9 to 14,
**characterized in**
**that** a laser beam (11) is driven over the surface (9) of the metal core (4) at a speed from 800 to 1200 mm/s, in particular about 1000 mm/s.
